# EUROPÄISCHE PATENTANMELDUNG

(11) **EP 1 291 917 A2**
(43) Veröffentlichungstag der Anmeldung: **12.03.2003**
(21) Anmeldenummer: 02019744.8
(22) Anmeldetag: 03.09.2002
(51) Int. Cl.: H01L 23/498, H01L 23/495

(54) **Elektrische Schaltungseinheit, insbesondere Leistungsmodul, und Verfahren zu deren Herstellung**

(30) Priorität: 10.09.2001 DE 10144323
(71) Anmelder: Delphi Technologies, Inc., Troy, MI 48007 (US)
(72) Erfinder: Gärtner, Markus, 42855 Remscheid (DE); Giesen, Marko, 51588 Nümbrecht (DE); Trommer, Frank O., 51588 Nümbrecht (DE); Stadler, Peter, 57482 Wenden (DE); Schulte, Thomas, 58540 Meinerzhagen Windebruch (DE)
(74) Vertreter: Manitz, Finsterwald & Partner GbR

(57) **Zusammenfassung**

Elektrische Schaltungseinheit, insbesondere Leistungsmodul, mit einer aus wenigstens einem Metallstanzteil gebildeten Leiterstruktur, wobei die Leiterstruktur mindestens teilweise in ein festes Isoliermaterial eingebettet ist. Die Schaltungseinheit zeichnet sich durch eine geringe Wärmeentwicklung und eine einfache Herstellbarkeit aus.

## Beschreibung

Die vorliegende Erfindung betrifft eine elektrische Schaltungseinheit, insbesondere ein Leistungsmodul, sowie ein Verfahren zu deren Herstellung.

Es ist bekannt, elektrische Schaltungseinheiten mit Hilfe von Schaltungsträgern in Form von Leiterplatten aufzubauen, auf denen die elektrischen Bauelemente aufgebracht und mittels aufgedruckter Leiterbahnen verbunden werden. Insbesondere bei hohen Strömen besteht das Problem, daß die Leiterbahnen eine erhebliche Dicke aufweisen müssen. Um dies zu erreichen, ist ein aufwendiges und entsprechend teures Laminierverfahren erforderlich.

Der Erfindung liegt die Aufgabe zugrunde, eine elektrische Schaltungseinheit und insbesondere ein Leistungsmodul anzugeben, die einen vorteilhaften Aufbau aufweist und daher günstig in der Herstellung ist. Darüber hinaus soll ein vorteilhaftes Verfahren zur Herstellung einer solchen Schaltungseinheit angegeben werden.

Diese Aufgabe wird gelöst durch eine elektrische Schaltungseinheit, insbesondere Leistungsmodul mit einer aus wenigstens einem Metallstanzteil gebildeten Leiterstruktur, wobei die Leiterstruktur mindestens teilweise in ein festes Isoliermaterial eingebettet ist.

Darüber hinaus wird diese Aufgabe durch ein Verfahren gemäß Anspruch 13 gelöst.

Durch Verwendung mindestens eines Metallstanzteils als Leiterstruktur kann auf kostengünstige Weise ein relativ großer Querschnitt der Leiter erreicht werden. Durch die Einbettung der Leiterstruktur in festes Isoliermaterial wird die mechanische Festigkeit der Schaltungseinheit gewährleistet.

Eine besonders günstige Herstellung ergibt sich, wenn das Isoliermaterial auf die Leiterstruktur aufgespritzt ist. Auch wird dadurch eine stabile Verbindung des Isoliermaterials mit der Leiterstruktur und damit eine hohe mechanische Festigkeit erzielt.

Nach einer besonderen Ausgestaltung der Erfindung ist mindestens ein elektrisches Bauteil, insbesondere Leistungselement, vorgesehen, das mit einer als elektrischer Anschluß ausgebildeten Seite auf das Metallstanzteil aufgesetzt ist. Das Metallstanzteil dient auf diese Weise direkt als Anschlußleitung für das elektrische Bauelement. Zugleich wirkt das Metallstanzteil aufgrund der flächigen Verbindung mit dem elektrischen Bauelement als effektive Wärmeableitung. Bei dem Bauelement kann es sich beispielsweise um einen Chip, insbesondere ein MOSFET handeln.

Besonders vorteilhaft kann die Leiterstruktur zur elektrischen Energieversorgung der elektrischen Bauelemente eingesetzt werden. Durch den möglichen großen Querschnitt der Leiterstruktur können problemlos auch hohe Ströme, beispielsweise im Bereich von 60 Ampère, übertragen werden, ohne daß die Leiterstruktur selbst große Wärmemengen erzeugt. Vielmehr kann sie aufgrund ihrer Wärmeleitfähigkeit zur Wärmeableitung effektiv beitragen.

Nach einer weiteren bevorzugten Ausgestaltung bildet das Isoliermaterial auf einer Seite der Leiterstruktur eine Stützfläche für einen Schaltungsträger. Zusätzlich zu den direkt auf der Leiterstruktur aufgesetzten elektrischen Bauelementen können dadurch vorteilhaft weitere elektrische Bauelemente in die erfindungsgemäße Schaltungseinheit integriert werden.

Der Schaltungsträger ist bevorzugt auch auf der zur Stützfläche weisenden Seite mit elektrischen Bauelementen versehen. Die Stützfläche kann hierfür insbesondere mindestens eine Vertiefung zur Aufnahme von elektrischen Bauelementen des Schaltungsträgers aufweisen. Die Bauelemente sind dadurch geschützt.

Nach einer weiteren Ausgestaltung der Erfindung ist eine der beiden Seiten der Leiterstruktur frei von Isoliermaterial gehalten. Auf dieser Seite kann vorteilhaft ein Kühlkörper angeordnet sein, der mit der Leiterstruktur wärmeleitend verbunden ist. Die Wärmeableitung kann dadurch optimiert werden.

Bevorzugt ist zwischen Kühlkörper und Leiterstruktur eine wärmeleitende, elektrisch isolierende Schicht vorgesehen. Dabei kann es sich um eine Folie oder einen Kleber handeln. Hierdurch wird ein guter Wärmekontakt zwischen dem Kühlkörper und der Leiterstruktur gewährleistet.

Nach einer weiteren Ausgestaltung der Erfindung ist die der Stützfläche abgewandte Seite des Schaltungsträgers mit einem Vergußmaterial, insbesondere einer Silikonschicht abgedeckt. Der Schaltungsträger und die auf dieser Seite angeordneten Bauelemente werden hierdurch geschützt.

Zusätzlich kann die Schaltungsträgerseite der Schaltungseinheit mit einem Deckel versehen sein. Der Deckel schützt die gesamte Einheit.

Das erfindungsgemäße Verfahren zur Herstellung einer elektrischen Schaltungseinheit umfaßt die folgenden Schritte:
- Ausstanzen der Leiterstruktur aus einer Metallplatte oder einem Metallband,
- Umspritzen der Leiterstruktur mit Isoliermaterial und gegebenenfalls Ausbilden der Stützfläche,
- gegebenenfalls Anbringen des Schaltungsträgers auf der Stützfläche,
- gegebenenfalls Aufsetzen der elektrischen Bauelemente auf das Metallstanzteil und
- gegebenenfalls Herstellen der elektrischen Verbindung zwischen den auf dem Metallstanzteil aufgesetzten Bauelementen und dem Schaltungsträger sowie dem Metallstanzteil.

Weitere vorteilhafte Ausgestaltungen des erfindungsgemäßen Herstellungsverfahrens ergeben sich aus den Ansprüchen und der nachfolgenden Beschreibung.

Ein Ausführungsbeispiel der Erfindung ist in der Zeichnung dargestellt und wird nachfolgend beschrieben. Es zeigen, jeweils in schematischer Darstellung:

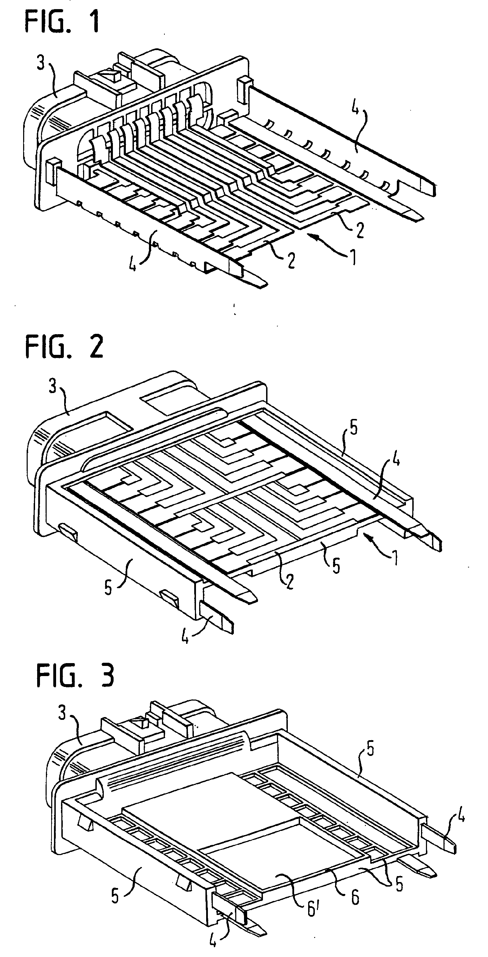

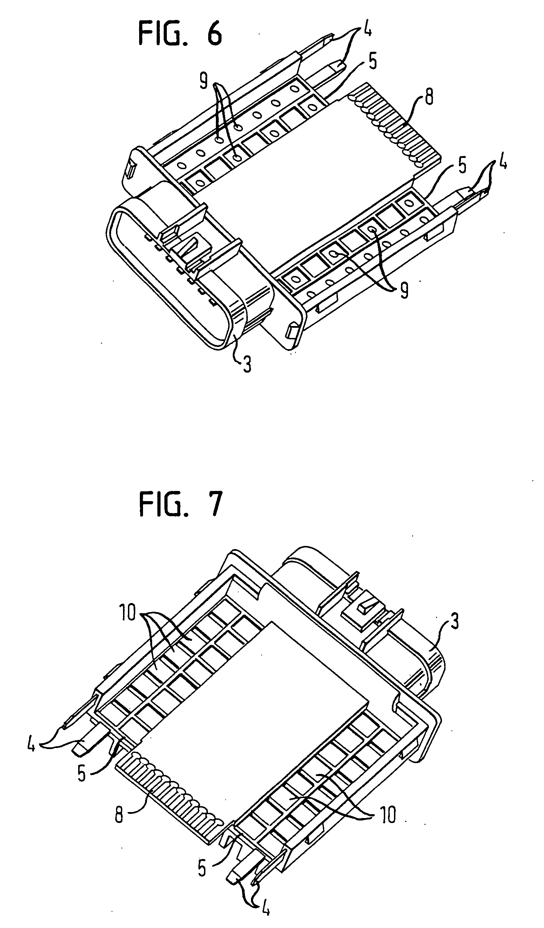

- Figuren 1 bis 12: eine perspektivische Ansicht einer erfindungsgemäßen Schaltungseinheit in verschiedenen Herstellungsstadien.

Figur 1 zeigt ein metallisches Stanzgitter 1, welches in zwei Ebenen verlaufende Leiterbahnen 2 umfaßt. Das Stanzgitter 1 ist in ein Steckergehäuse, sog. Header eingesteckt, welcher zusätzlich mit seitlich zum Metallstanzgitter 1 verlaufenden Stromschienen 4 versehen ist.

Das Metallstanzgitter 1 wird anschließend, wie in Figur 2 und 3 dargestellt, mit Isoliermaterial 5 derart umspritzt, daß das Metallstanzgitter 1 auf einer Seite frei von Isoliermaterial bleibt, während auf der anderen Seite eine Stützfläche 6 für einen Schaltungsträger ausgebildet wird.

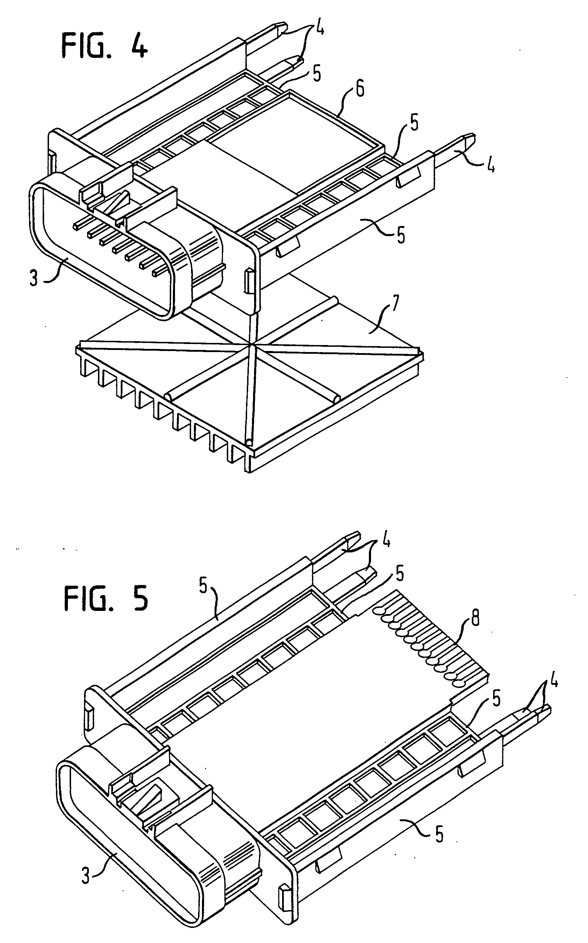

Auf die von Isoliermaterial frei gehaltene Seite des Metallstanzgitters 1 wird dann gemäß Figur 4 ein Kühlkörper 7 aufgebracht. Hierfür wird auf den Kühlkörper 7 Wärmeleitkleber aufgetragen oder er wird mit einer Wärmeleitfolie beklebt, bevor er auf das Metallstanzgitter 1 aufgesetzt wird.

Als nächstes wird, wie in Figur 5 dargestellt, auf die Stützfläche 6 eine Leiterplatte 8 als Schaltungsträger mit weiteren Bauelementen aufgebracht. Die Bauelemente befinden sich dabei auch auf der der Stützfläche 6 zugewandten Seite. Diese werden von einer Vertiefung 6' in der Stützfläche 6 aufgenommen. Die Verbindung zwischen Leiterplatte 8 und Stützfläche 6 erfolgt bevorzugt durch auf die Stützfläche 6 zuvor aufgebrachten Kleber.

Die neben der Leiterplatte 8 befindlichen Abschnitte des Metallstanzgitters 1 sind ebenfalls von Isoliermaterial frei gehalten. Auf sie werden als nächstes gemäß Figur 6 Punkte 9 von elektrischem Verbindungsmaterial, insbesondere Leitkleber, aufgebracht. Anschließend werden elektrische Bauelemente 10 mit einer als elektrischer Anschluß dienenden Seite, insbesondere MOSFET, auf die mit den Punkten 9 versehenen Abschnitte des Metallstanzgitters 1 aufgesetzt, wie in Figur 7 gezeigt ist. Danach wird, wie in Figur 8 gezeigt, ein zweites Steckergehäuse (Header) 21 angebracht.

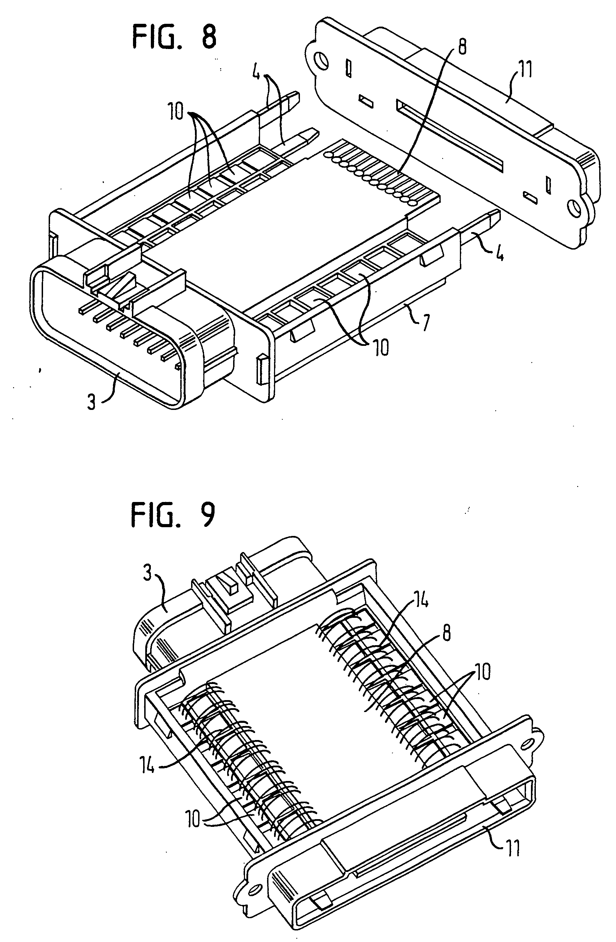

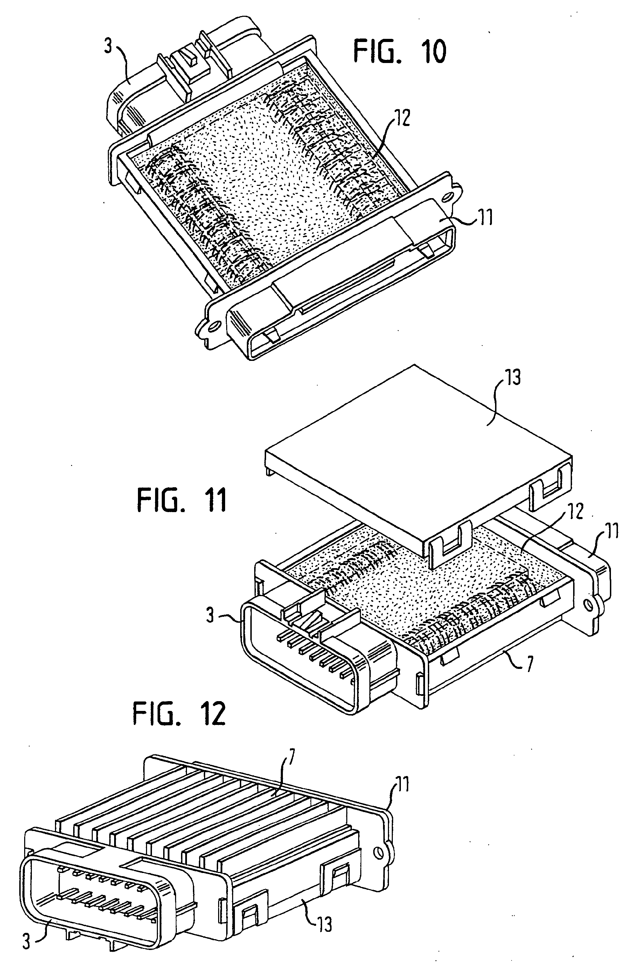

Als nächsten Schritt zeigt Figur 9 die Herstellung der elektrischen Verbindungen 14 (Bonden) zwischen den MOSFET 10 und der Leiterplatte 8 sowie den MOSFET 10 und dem Metallstanzgitter 1. Nach Herstellung dieser Verbindungen wird eine Funktionsprüfung durchgeführt. Sodann wird die Leiterplattenseite der elektrischen Schaltungseinheit mit einem Vergußmaterial, insbesondere einer Silikonschicht 12 abgedeckt, wie in Figur 10 gezeigt ist. Das Vergußmaterial wird, beispielsweise durch UV-Licht, ausgehärtet. Danach wird, wie in Figur 11 gezeigt, über das Vergußmaterial 12 ein Deckel 13 aufgesetzt. Damit ist die Herstellung der in Figur 12 nochmals von der zweiten Seite gezeigten Schaltungseinheit abgeschlossen, und es kann ein abschließender Funktionstest durchgeführt werden.

Es wird so eine Schaltungseinheit erhalten, die insbesondere als Leistungsmodul einsetzbar ist. Durch die Verwendung eines Metallstanzgitters 1 können hohe Leitungsquerschnitte erreicht werden, ohne daß ein kostenaufwendiges Laminierverfahren eingesetzt werden muß. Die Einbettung in elektrisches Isoliermaterial 5 ermöglicht eine hohe mechanische Stabilität der Einheit. Gleichzeitig bildet das Isoliermaterial 5 vorteilhafterweise eine Stützfläche 6 für eine Leiterplatte 8 mit weiteren Bauelementen, so daß insgesamt ein komplexes Modul darstellbar ist. Dennoch bleibt die Herstellung insgesamt verhältnismäßig einfach und kostengünstig.

### Bezugszeichenliste

- 1: Metallstanzgitter/Leiterstruktur
- 2: Leiterbahn
- 3: Steckergehäuse (Header)
- 4: Stromschiene
- 5: Isoliermaterial
- 6: Stützfläche
- 6': Vertiefung in 6
- 7: Kühlkörper
- 8: Leiterplatte
- 9: Leitkleberpunkte
- 10: MOSFET
- 11: zweites Steckergehäuse (Header)
- 12: Vergußmaterialschicht
- 13: Deckel
- 14: Elektrische Verbindung

## Patentansprüche

1. Elektrische Schaltungseinheit, insbesondere Leistungsmodul, mit einer aus wenigstens einem Metallstanzteil (1) gebildeten Leiterstruktur, wobei die Leiterstruktur (1) mindestens teilweise in ein festes Isoliermaterial (5) eingebettet ist.

2. Schaltungseinheit nach Anspruch 1,
**dadurch gekennzeichnet,**
**daß** das Isoliermaterial (5) auf die Leiterstruktur (1) aufgespritzt ist.

3. Schaltungseinheit nach Anspruch 1 oder 2,
**dadurch gekennzeichnet,**
**daß** mindestens ein elektrisches Bauelement (10), insbesondere Leistungselement, vorgesehen ist, das mit einer als elektrischer Anschluß ausgebildeten Seite auf das Metallstanzteil (1) aufgesetzt ist.

4. Schaltungseinheit nach Anspruch 3,
**dadurch gekennzeichnet,**
**daß** die Leiterstruktur (1) der elektrischen Energieversorgung des elektrischen Bauelementes (10) dient.

5. Schaltungseinheit nach einem der vorhergehenden Ansprüche,
**dadurch gekennzeichnet,**
**daß** das Isoliermaterial (5) auf einer Seite der Leiterstruktur (1) eine Stützfläche (6) für einen Schaltungsträger (8) bildet.

6. Schaltungseinheit nach einem der vorhergehenden Ansprüche,
**dadurch gekennzeichnet,**
**daß** der Schaltungsträger (8) auf seiner zur Stützfläche (6) weisenden Seite mit elektrischen Bauelementen versehen.

7. Schaltungseinheit nach Anspruch 6,
**dadurch gekennzeichnet,**
**daß** die Stützfläche (6) mit mindestens einer Vertiefung (6') zur Aufnahme von elektrischen Bauelementen des Schaltungsträgers (8) versehen ist.

8. Schaltungseinheit nach einem der vorhergehenden Ansprüche,
**dadurch gekennzeichnet,**
**daß** eine der beiden Seiten der Leiterstruktur (1) frei von Isoliermaterial (5) gehalten ist.

9. Schaltungseinheit nach Anspruch 8,
**dadurch gekennzeichnet,**
**daß** auf der freien Seite der Leiterstruktur (1) ein Kühlkörper (7) angeordnet ist, der mit der Leiterstruktur (1) wärmeleitend verbunden ist.

10. Schaltungseinheit nach Anspruch 9,
**dadurch gekennzeichnet,**
**daß** zwischen Kühlkörper (7) und Leiterstruktur (1) eine wärmeleitende, elektrisch isolierende Schicht vorgesehen ist.

11. Schaltungseinheit nach einem der vorhergehenden Ansprüche,
**dadurch gekennzeichnet,**
**daß** die der Stützfläche (6) abgewandte Seite des Schaltungsträgers (8) mit einem Vergußmaterial, insbesondere mit einer Silikonschicht (12) abgedeckt ist.

12. Schaltungseinheit nach einem der vorhergehenden Ansprüche,
**dadurch gekennzeichnet,**
**daß** die Schaltungsträgerseite der Schaltungseinheit mit einem Dekkel (13) versehen ist.

13. Verfahren zur Herstellung einer elektrischen Schaltungseinheit nach Anspruch 1,
**gekennzeichnet durch** die folgenden Schritte:
- Ausstanzen der Leiterstruktur (1) aus einer Metallplatte oder einem Metallband,
- Umspritzen der Leiterstruktur (1) mit Isoliermaterial (5) und gegebenenfalls Ausbilden der Stützfläche (6),
- gegebenenfalls Anbringen des Schaltungsträgers (8) auf der Stützfläche (6),
- gegebenenfalls Aufsetzen der elektrischen Bauteile (10) auf das Metallstanzteil (1) und
- gegebenenfalls Herstellen der elektrischen Verbindung (14) zwischen den auf dem Metallstanzteil (1) aufgesetzten Bauteilen (10) und dem Schaltungsträger (8) sowie dem Metallstanzteil (1).

14. Verfahren nach Anspruch 13,
**dadurch gekennzeichnet,**
**daß** auf die freie Seite der Leiterstruktur (1) ein Kühlkörper (7) aufgebracht wird.

15. Verfahren nach Anspruch 14,
**dadurch gekennzeichnet,**
**daß** zwischen Kühlkörper (7) und Leiterstruktur (1) eine elektrisch isolierende Wärmeleitschicht eingebracht wird.

16. Verfahren nach Anspruch 15,
**dadurch gekennzeichnet,**
**daß** als Wärmeleitschicht eine Folie aufgeklebt wird.

17. Verfahren nach Anspruch 15,
**dadurch gekennzeichnet,**
**daß** als Wärmeleitschicht ein Kleber aufgetragen wird.

18. Verfahren nach einem der Ansprüche 13 bis 17,
**dadurch gekennzeichnet,**
**daß** die Bauelemente (10) auf dem Metallstanzteil (1) mittels eines elektrisch leitenden Verbindungsmittels, insbesondere mittels eines Leitklebers (9) befestigt werden.

19. Verfahren nach einem der Ansprüche 13 bis 18,
**dadurch gekennzeichnet,**
**daß** vor dem Herstellen der elektrischen Verbindung (14) zwischen den Bauelementen (10) auf dem Metallstanzteil (1) und dem Schaltungsträger (8) sowie dem Metallstanzteil (1) eine gemeinsame Wärmebehandlung für alle verwendeten Verbindungsmittel durchgeführt wird.

20. Verfahren nach einem der Ansprüche 13 bis 19,
**dadurch gekennzeichnet,**
**daß** der Schaltungsträger (8) auf seiner der Stützfläche (6) abgewandten Seite mit einem Vergußmaterial, insbesondere einer Silikonschicht (12) abgedeckt wird.

21. Verfahren nach einem der Ansprüche 13 bis 20,
**dadurch gekennzeichnet,**
**daß** vor dem Vergießen des Vergußmaterials (12) ein Funktionstest durchgeführt wird.

22. Verfahren nach einem der Ansprüche 13 bis 21,
**dadurch gekennzeichnet,**
**daß** auf die Schaltungsträgerseite der Einheit ein Deckel (13) aufgebracht wird.

23. Verfahren nach einem der Ansprüche 13 bis 22,
**dadurch gekennzeichnet,**
**daß** ein abschließender Funktionstest durchgeführt wird.
